# EUROPEAN PATENT APPLICATION

(11) **EP 3 828 131 A1**
(43) Date of publication of application: **02.06.2021**
(21) Application number: 19841106.8
(22) Date of filing: 25.07.2019
(51) Int. Cl.: B82Y 40/00

(54) **METHOD FOR DEPOSITING ELEMENTS ON A SUBSTRATE OF INTEREST AND DEVICE**

(30) Priority: 25.07.2018 ES 201830757
(71) Applicant: Consejo Superior De Investigaciones Científicas, 28006 Madrid (ES); Universidad De Zaragoza, 50009 Zaragoza (ES)
(72) Inventor: DE TERESA NOGUERAS, José María, 50009 Zaragoza (ES); CÓRDOBA CASTILLO, Rosa, 50009 Zaragoza (ES); TORRES MOLINA, Teobaldo, 50009 Zaragoza (ES); STROHAUER, Stefan, 50009 Zaragoza (ES)
(74) Representative: Pons
(86) International application number: PCT/ES2019/070526
(87) International publication number: WO 2020/021149

(57) **Abstract**

The invention relates to a method for depositing new elements on a substrate of interest by means of a beam of focused ions and a platform for cooling the substrate of interest to cryogenic temperatures that can also rough out defective elements that are located on same. In addition, the invention relates to a device that comprises all the means necessary for carrying out the method, in particular the means necessary for condensing precursor gases on the surface of the substrate of interest at cryogenic temperatures. The method and the device of the invention can be used to remove and repair, for example, metal contacts of an electronic device or of an integrated circuit, or to repair, for example, portions of an optical lithography mask. Therefore, the present invention is applicable in the electronics industry and in the field of nanotechnology.

## Description

The invention relates to a method for depositing new elements on a substrate of interest by means of a beam of focused ions and a platform for cooling the substrate of interest to cryogenic temperatures that can also rough out defective elements that are located on same.

In addition, the invention relates to a device that comprises all the means necessary for carrying out the method, in particular the means necessary for condensing precursor gases on the surface of the substrate of interest at cryogenic temperatures.

The method and the device of the invention can be used to remove and repair, for example, metal contacts of an electronic device or of an integrated circuit, or to repair, for example, portions of an optical lithography mask. Therefore, the present invention is applicable in the electronics industry and in the field of nanotechnology.

### BACKGROUND OF THE INVENTION

In the semiconductor industry, for more than 25 years, companies in the sector have been using Focused Ion Beam (FIB) and Focused Ion Beam Induced Deposition (FIBID) roughing out techniques.

In the case of the FIB technique, a focused ion beam (typically accelerated to 30 kV) has sufficient linear energy and momentum for causing a local roughing out of a material, being therefore a subtractive lithography technique.

In the case of the FIBID technique, and by means of an injector, a precursor gas is applied that is adsorbed to the work surface, generally at room temperature, and ion beam scanning dissociates the precursor gas, causing the growth of a material locally in the scanned area, referred to as deposit, constituting an additive lithographic technique.

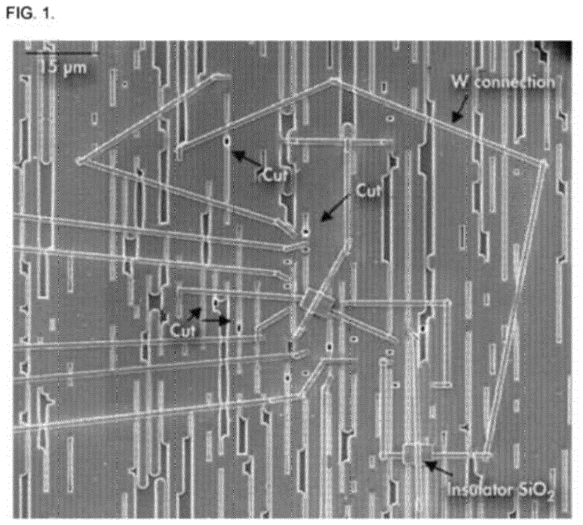

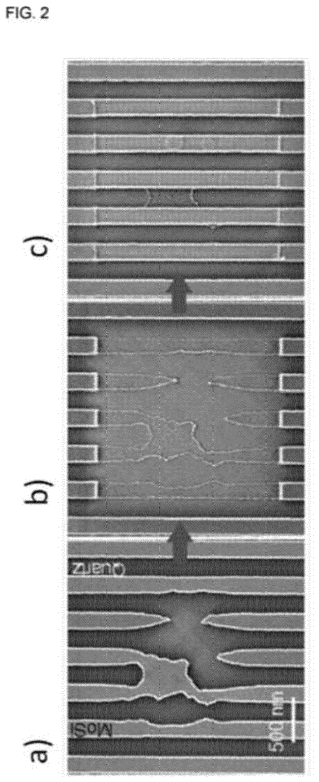

The technique enables electrical contacts in integrated circuits to be repaired or reconfigured [D. Xia et al., Journal of Vacuum Science and Technology B 33 (2015) 06F501], as seen in Figure 1. This process is known as *Circuit edit.* The technique also serves to restore defective portions in lithography masks used in the manufacture of microelectronic devices [Z. Cui et al., Journal of Vacuum Science and Technology B 14 (1996) 3942; T. Bret et al., Applied Physics A 117 (2014) 1607], as seen in Figure 2. Basically, existing methods consist of first using a focused ion beam (or a focused electron beam assisted by reactive gases) to remove the defective areas from the masks and secondly redoing said areas by growing the necessary deposits using the FIBID technique or the equivalent using a focused electron beam (called FEBID). This process is known by the name of *mask repair.*

It is common for both FIB and FIBID techniques to be integrated in combination with a scanning electron microscope, into a microscope called FIB-SEM (Scanning Electron Microscope, or SEM). We are talking about advanced microscopes that cost around a million euros per unit and that companies that manufacture microelectronic components sometimes need by the dozens in the case of mass production in microelectronic foundries. Therefore, a significant advance in the efficiency of the FIB and FIBID processes can have a high economic impact in editing microelectronic circuits and in repairing lithography masks.

For the applications described, the FIBID technique exhibits two notable limitations: on the one hand, the growth rate of the deposits at room temperature is very slow and on the other hand, many defects are introduced into the work surface/substrate and/or into the deposited material/deposit, associated with the use of ions (implantation, amortisation, extrinsic doping, etc.).

Therefore, it is necessary to develop fast methods for depositing elements by means of a focused ion beam that also minimise the appearance of defects.

### DESCRIPTION OF THE INVENTION

The present invention relates to a method for depositing new elements on a substrate of interest by means of a beam of focused ions and a platform for cooling the substrate of interest to cryogenic temperatures, that can also rough out defective elements that are located on said substrate of interest.

In the present invention "the elements" can be physically linked, such as, for example, the metal contacts of an electronic device, or they may be isolated as with the various parts of a lithography mask.

In the present invention the deposited "element" may have any composition, for example, it can be composed of a metal or an alloy in the event that metal elements of an electronic device are to be deposited.

In the present invention, the "element" can also have any geometry: it can be a sheet, a microwire, a nanowire, a circle, etc.

The term "defective element" is understood in the present invention as that defective or deteriorated element that makes the electronic device, the integrated circuit or lithography mask stop working or malfunction.

In addition, the present invention relates to a device that comprises all the means necessary for carrying out the method of the present invention, in particular the means necessary for condensing precursor gases on the surface of the substrate of interest at cryogenic temperatures.

The method and the device of the present invention can be used to remove and repair electrical contacts of an integrated circuit or to repair defective portions of an optical lithography mask, so the present invention is of interest in the sector of manufacturing and repairing devices of the electronic industry, and in the field of nanotechnology for manufacturing, for example, sensors and devices based on quantum technologies.

In the present invention, the term "substrate of interest" refers to a support of an electronic device, of an integrated circuit, or an optical lithography mask.
- For the application in mask repair, the substrate of interest, in addition to containing elements with chromium, may contain non-conductive elements such as silica, quartz, gelatin, silver halide, polystyrene, etc.
- For the application of integrated circuits editing (removal and/or repair), the substrate of interest must have conductive elements that ensure electrical conductivity. Examples of the composition of conductive elements in the circuit editing industry are: copper, gold, ruthenium, aluminium, titanium, chromium, nickel, molybdenum, silver, palladium, silicon, tantalum.

The advantages of the method and the device of the present invention are:
- the growth rate of conductive and non-conductive elements on the substrate of interest is increased
- damage to the substrate of interest is minimised
- the implantation of atoms of the beam of ions such as gallium atoms, the amortisation effects and extrinsic doping caused by the beam of gallium ions are minimized.

In a first aspect, the present invention relates to a method for depositing new elements (8) on a substrate of interest (3) (hereinafter "the method of the present invention"), by means of a device that comprises
- a microscope (1) configured for visualising and identifying the position of the surface of the substrate of interest (3) and of the defective and new elements (7 and 8) that are on said substrate of interest (3)
- a focused ion beam system (2) configured for emitting a focused ion beam on the position of the surface of the substrate of interest (3) and of the defective and new elements (7 and 8) identified by the microscope (1) and for depositing new elements (8) on said substrate of interest (3)
- a precursor gas injector (6) directed towards said substrate of interest (3) and configured for depositing the new elements (8) on the substrate of interest (3) and
- a support platform of the substrate (4) connected to a cooling element (5) on which the substrate of interest is located, and configured for condensing the precursor gas coming from the precursor gas injector (6) on the substrate of interest (3),
wherein the microscope (1) and the focused ion beam system (2) are integrated into a device that contains them,
wherein there is a distance between the precursor gas injector (6) and the support platform of the substrate (4), and
wherein said method is characterised in that it comprises the following steps
a) identifying the position of the surface of the substrate of interest (3) on which new elements (8) are to be deposited with the help of a microscope (1),
b) depositing the new elements (8) on the position of the surface identified in step (a), forming a condensed precursor layer on the substrate of interest (3) with a thickness of up to 1 µm at a temperature lower than the condensation temperature of the precursor, irradiating the position of the surface identified in step (a) on which new elements (8) are to be deposited with a focused ion beam (2) and evaporating the non-irradiated condensed precursor layer.

The method of the present invention can be repeated as many times as necessary or desired, without the substrate of interest (3) being damaged by the continuous condensations of the precursor gas.

Step (a) of the method of the present invention is related to identifying the position of the surface of the substrate of interest (3) on which new elements (8) are to be deposited with the help of a microscope (1), such as a scanning electron microscope or the ion microscope itself.

Step (b) of the method of the present invention relates to depositing the new elements (8) on the position of the surface identified in step (a) by means of a variation of the focused ion beam induced deposition (FIBID) technique.

The method of the present invention, specifically in step (b), further relates to the formation of a condensed precursor layer on the substrate of interest (3) with a thickness of up to 1 µm at a temperature lower than the condensation temperature of the substrate with the help of a support platform of the substrate (4) connected to a cooling element (5) configured for condensing the precursor gas coming from the precursor gas injector (6) on the substrate of interest (3). In the present invention, the condensed precursor layer is homogeneous.

In the present invention the term "precursor or precursor gas" refers to that precursor gas of the new elements (8).

The thickness of the condensed precursor layer is established by controlling the time during which the precursor gas injection valve is open and the distance between the precursor injector and the substrate. The condensed layer has a thickness of between 10 nm and 30 nm in the case of using a gallium source FIB system which works at 30 kV, as shown in the exemplary embodiment of the invention.

In a preferred embodiment of the method of the present invention, the focused ion beam (2) is selected from gallium, helium, neon, hydrogen, lithium, oxygen, xenon, argon, silicon, cobalt, germanium, gold, bismuth and metal alloys. More preferably, the focused ion beam (2) is selected from gallium, hydrogen, helium, neon, xenon, argon, lithium, oxygen, silicon, cobalt, germanium, gold, bismuth and metal alloys.

Examples of metal alloys are AuSi, AuGe, AuGeSi, CoNd, CoGe, ErNi, ErFeNiCr, NiB, Gain.

In a preferred embodiment of the method of the present invention, the condensed precursor layer is formed on the substrate of interest (3) by cooling the substrate to cryogenic temperatures below -80 °C, for example using liquid nitrogen as a cooling element.

In a preferred embodiment of the present invention, the method relates to depositing elements for electrical or electronic circuits and the precursor preferably gives rise to metal deposits/elements.

In another preferred embodiment of the method of the present invention, the precursor is selected from W(CO)₆, Co₂(CO)₈, Fe₂(CO)₉, HCO₃Fe(CO)₁₂, (CH₃)₃PtCp(CH₃), CuC₁₆O₆H₂₆ or gold precursors such as dimethylgold(III)-acetyl-acetonate, dimethylgold(III)-trifluoroacetyl-acetonate, dimethylgold(III)-hexafluoroacetyl-acetonate, PF₃AuCl, Au(CO)CI, [ClAu^{III}Me₂]₂, ClAu^{I}(SMe₂), ClAu^{I}(PMe₃) and MeAu^{I}(PMe₃).

Next, the position of the surface of the substrate of interest (3) on which new elements (8) are to be deposited, which had been previously identified in step (a), is irradiated with a focused ion beam (2).

The localised irradiation of the condensed precursor layer is carried out by scanning the surface of the substrate of interest (3) with a focused ion beam for a certain time; said time depends on the scanned area and the working conditions. The irradiation carried out by the ion beam causes physicochemical changes in the condensed layer.

In a preferred embodiment of the method of the present invention, the voltage applied for generating the ion beam in step (d) is comprised between 5 kV and 50 kV.

In another preferred embodiment of the method of the present invention, irradiation with a focused ion beam (2) of step (d) is carried out in a range that is comprised between 3 x 10⁻⁴ nC/µm² and 9 x 10⁻⁴ nC/µm².

Lastly, the non-irradiated condensed precursor layer is allowed to evaporate at a temperature higher than the condensation temperature of the precursor on the substrate of interest (3), turning off the flow of cooling element that reaches the support platform of the substrate (4), for example leaving the substrate of interest at room temperature.

In another preferred embodiment of the method of the present invention, the method comprises an additional step (a') prior to step (a), of identifying the defective elements (7) of the substrate of interest (3) with the help of a microscope and roughing them out with the help of a focused ion beam (2).

Therefore, the method of this preferred embodiment relates to a method for depositing new elements (8) on a substrate of interest (3) (hereinafter "the method of the present invention"), by means of a device that comprises
- a microscope (1) configured for visualising and identifying the position of the surface of the substrate of interest (3) and of the defective and new elements (7 and 8) that are on said substrate of interest (3)
- a focused ion beam system (2) configured for emitting a focused ion beam on the position of the surface of the substrate of interest (3) and of the defective and new elements (7 and 8) identified by the microscope (1) and for depositing new elements (8) on said substrate of interest (3)
- a precursor gas injector (6) directed towards said substrate of interest (3) and configured for depositing the new elements (8) on the substrate of interest (3) and
- a support platform of the substrate (4) connected to a cooling element (5) on which the substrate of interest is located, and configured for condensing the precursor gas coming from the precursor gas injector (6) on the substrate of interest (3),
wherein the microscope (1) and the focused ion beam system (2) are integrated into a device that contains them,
wherein there is a distance between the precursor gas injector (6) and the support platform of the substrate (4), and
wherein said method is characterised in that it comprises the following steps
a') identifying the defective elements (7) of the substrate of interest (3) with the help of a microscope and roughing them out with the help of a focused ion beam (2),
a) identifying the position of the surface of the substrate of interest (3) on which new elements (8) are to be deposited with the help of a microscope (1),
b) depositing the new elements (8) on the position of the surface identified in step (a), forming a condensed precursor layer on the substrate of interest (3) with a thickness of up to 1 µm at a temperature lower than the condensation temperature of the precursor, irradiating the position of the surface identified in step (a) on which new elements (8) are to be deposited with a focused ion beam (2) and evaporating the non-irradiated condensed precursor layer.

Another aspect of the present invention relates to the device to rough out defective elements (7) that are located on a substrate of interest (3) and depositing new elements (8) on said substrate of interest (3) (hereinafter the device of the present invention) within a high vacuum growth chamber (9) characterised in that it comprises the following means:
- a microscope (1) configured for visualising and identifying the position of the surface of the substrate (3) and of the defective and new elements (7 and 8) that are on said substrate of interest (3)
- a focused ion beam system (2) configured for irradiating the position of the surface of the substrate (3) and of the defective and new elements (7 and 8) identified by the microscope (1) with a focused ion beam and to rough out defective elements (7) that are located on the substrate of interest (3) and depositing new elements (8) on said substrate of interest (3)
- a precursor gas injector (6) directed towards said substrate of interest (3) configured for depositing the new elements (8) on the substrate of interest (3) and
- a support platform of the substrate (4) connected to a cooling element (5) on which the substrate of interest (3) is located, configured for condensing the precursor gas coming from the precursor gas injector (6) on the substrate of interest (3),
wherein the microscope (1) and the focused ion beam system (2) are integrated into a device that contains them, and
wherein there is a distance between the precursor gas injector (6) and the support platform of the substrate (4).

The distance between the precursor gas injector (6) and the platform of the substrate of interest (4) influences the local pressure caused by the precursor gas on the surface of the substrate of interest (3) and, therefore, the temperature at which the condensation of said precursor gases is caused on the surface of the substrate of interest. The distance will vary as a function of the inner diameter of the precursor gas injector (6) and the distance between the end of the precursor gas injector (6) and the support platform of the substrate (4).

Throughout the description and the claims, the word "comprises" and its variants do not intend to exclude other technical features, additives, components or steps. For those skilled in the art, other objects, advantages and features of the invention may be partially deduced from both the description and the embodiment of the invention. The following examples and figures are provided by way of illustration, and are not intended to limit the present invention.

### BRIEF DESCRIPTION OF THE FIGURES

**FIG. 1** Image of an integrated circuit wherein cuts have been made using the FIB technique and W metal contacts using the FIBID technique to reconfigure the behaviour thereof. This image is part of the state of the art.
**FIG. 2****.** Images of a mask used for optical lithography taken with an SEM microscope. (a) The mask exhibits defective material in a certain area. (b) Using the FIB technique the material from the defective area can be roughed out. (c) Using FIBID, deposits can be created to restore the defective area. This image is part of the state of the art.
**FIG. 3****.** Diagram of the device of the present invention
   (1) Microscope
   (2) Focused ion beam system
   (3) Surface of the substrate
   (4) Support platform of the substrate of interest
   (5) Cooling element
   (6) Precursor gas injector
   (7) Defective or damaged elements
   (8) New elements
   (9) Growth chamber
**FIG. 4****.** The images show SEM images that enable the degree of homogeneity of the condensed W(CO)₆ precursor layer on the substrate to be assessed as a function of the substrate temperature at a distance of 5 mm between the injector-substrate.
**FIG. 5****.** Porousness of the condensed layer as a function of the irradiation dose. (a) dose= 4.21 x 10⁻⁵ nC/µm², (b) dose= 3.57 x 10⁻⁴ nC/µm².
**FIG. 6****.** Electrical resistance as a function of the irradiation dose of the condensed layer.
**FIG. 7****.** Time necessary for growing W(CO)₆ deposits of the same thickness and same area as a function of the substrate temperature. It is observed that when the precursor is in the condensed phase (-80 °C), the time required is reduced by a factor close to 1000.
**FIG. 8****.** (a) Scanning electron microscopy image of the structure grown by means of the method of the present invention using the precursor W(CO)₆ in order to assess the electrical properties thereof. (b) Measurements of voltage (V) versus current (I) of 3 samples as that shown in (a), from where the metallic behaviour (linear dependence V vs I) is inferred and from where an average resistivity value close to that obtained in a method carried out at a substrate temperature around room temperature (standard FIBID) is obtained.
**FIG. 9****.** Scanning electron microscopy images of nanowires grown using the device and method of the present invention using two different irradiation doses. (a) 8 x 10⁻⁴ nC/µm² irradiation dose. (b) 6 x 10⁻⁴ nC/µm² irradiation dose. In both cases, the high lateral resolution of the method and the minimum proximity effect are observed, which enables two close threads that are independent to be obtained.
**FIG. 10****.** Transmission electron microscopy image of one of the condensed layers, wherein it is observed that it exhibits a total thickness of less than 30 nm.

### EXAMPLES

### Example 1:

To demonstrate that the method of the present invention is viable and useful for editing/repairing, for example, integrated electronic circuits and lithography masks used in the manufacture of microelectronic devices in the semiconductor industry, our experiments have focused on the use of the precursor W(CO)₆, which enables tungsten W to be deposited and thus repair conductive elements.

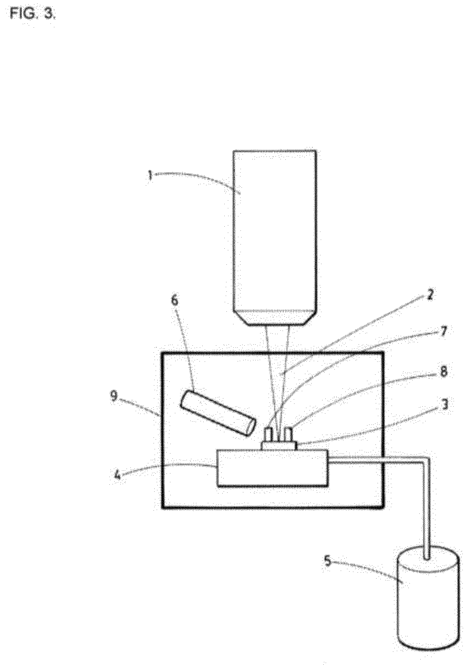

For this, the device that is outlined in Figure 3 has been used and which comprises the following elements:
- a microscope (1) configured for visualising and identifying the position of the surface of the substrate (3) and of the defective and new metal elements (7 and 8) that are on said substrate of interest (3)
- a focused ion beam system (2) configured for emitting a focused ion beam on the position of the surface of the substrate of interest (3) and of the defective and new metal contacts (7 and 8) identified by the microscope (1) and for roughing out defective contacts (7) that are located on the substrate of interest (3) and/or depositing new metal contacts (8) on said substrate of interest (3)
- a precursor gas injector (6) directed towards said substrate of interest (3) configured for depositing the new metal contacts (8) on the substrate of interest (3) and
- a support platform of the substrate of interest (4) connected to a cooling element (5) on which the substrate of interest (3) is located, configured for condensing the precursor gas coming from the precursor gas injector (6) on the substrate of interest (3),
wherein the microscope (1) and the focused ion beam system (2) are integrated into a device that contains them.

First, the general method to rough out defective metal contacts (7) of the substrate of interest (3) involves imaging with an optical, electronic (SEM) or ion (FIB) microscope to detect the defective area. Next, scanning with the ion beam (FIB) is carried out to remove defective material from said area. Finally, an inspection of the place is carried out again to observe that the defective metal contact has disappeared from said area.

The general method for depositing new metal contacts (8) on the substrate of interest (3) can be described as follows: The substrate of interest (3) on which new metal contacts (8) are to be deposited is introduced into the growth chamber (9). The inlet valve of the cooling element (5) which is extracted from a bottle of liquid nitrogen opens. This cooling element circulates to the support platform of the substrate of interest (4) wherein the substrate of interest (3) rests, which can be cooled from room temperature to the temperature of the liquid nitrogen (-196 °C). The precursor injector valve (6) opens, and the precursor comes out in the form of gas and condenses on the substrate of interest (3) forming a layer of condensed precursor on the substrate of interest (3). The thickness of this condensed layer is controlled through the time the valve remains open. Next, the condensed layer is irradiated by scanning the ion beam (2) over same and subsequently the substrate of interest (3) is allowed to heat to room temperature so that the condensed layer evaporates except in the areas irradiated with the ion beam (2) wherein a metal material remains on the substrate of interest (3) that corresponds to the shape of the scanning of the ion beam (2).

The substrate is cooled to cryogenic temperatures of around -100 °C, causing the condensation of the precursor gas W(CO)₆ on the surface of the substrate when it makes contact with it. The thickness of the condensed layer is established by controlling the time during which the precursor gas injection valve is open and the distance between the precursor gas injector (6) and the substrate of interest (3). In our working conditions, the optimum thickness of the condensed layer is 10-30 nm, since this is the average depth reached by the beam of gallium ions accelerated at 30 kV. Localised irradiation of the condensed layer of W(CO)₆ is carried out by scanning a focused ion beam for a certain time. In our experiments we optimised this time that depends on the scanned area, obtaining the corresponding optimal irradiation doses. The optimal irradiation dose depends on the working conditions and in our case it has been found to be 5.5 x 10⁻⁴ nC/µm². The irradiation carried out by the ion beam causes physicochemical changes in the condensed layer. These changes remain latent until the condensed layer evaporates as the substrate is heated to room temperature. As a result, the deposit only remains in the area irradiated by the beam of gallium ions and the rest of the layer evaporates. In this way we manage to grow a deposit on the area of interest and with the specified shape.

The condensation temperature of the precursor gas W(CO)₆ depends on the distance between the precursor gas injector (6) and the support platform (4) where the substrate of interest (3) rests, surely due to the fact that the local pressure of the precursor on the condensation surface changes with distance and therefore, if the local pressure changes, the condensation temperature will change.

The following table 1 illustrates the phenomenon:

| | | | |
|---|---|---|---|
| Distance between injector-support of the substrate | 1 mm | 5 mm | 10 mm |
| Temperature at which condensation is first observed | -20 °C | -30 °C | -60 °C |
| Temperature at which a homogeneous layer of condensation is obtained | -30 °C | -80 °C | -80 °C |
| Condensed layer thickness for the same injector valve opening time (10 s) | 6000 nm | 400 nm | 10-30 nm |

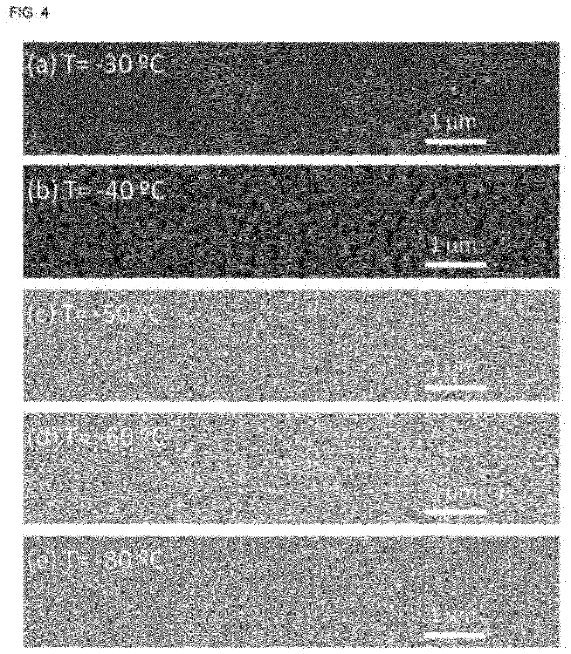

Figure 4 shows the condensed layer at different substrate temperatures: the formation of a homogeneous condensed layer only occurs when the substrate temperature is - 80 °C.

We were able to deduce from these results that the optimum working conditions occur at substrate temperatures equal to or lower than - 80 °C and for a distance between injector-substrate of 10 mm since a higher temperature implies inhomogeneity of the condensed layer and a distance of less than 10 mm between injector-substrate implies an excessively thick condensed layer for subsequent irradiation.

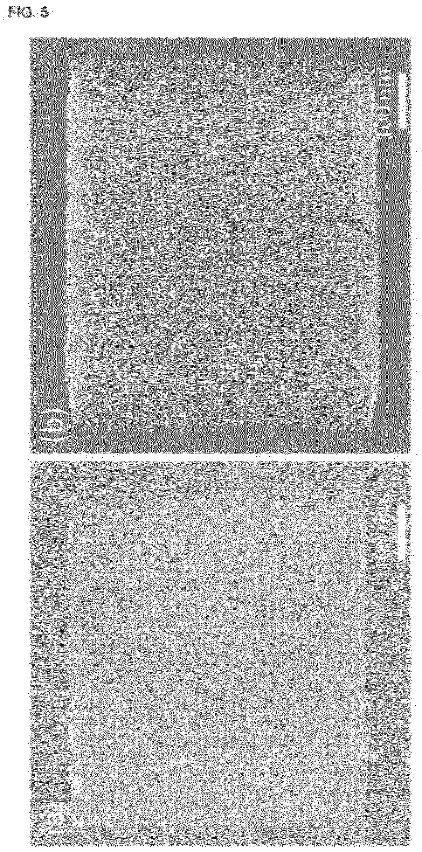

We also studied the influence of the irradiation dose on the degree of porosity of the deposit: below, Figure 5 shows two images of deposits created under the same conditions except that the one on the right has been subjected to an irradiation dose 10 times higher than that on the left. The one on the left shows a high degree of porosity that is not suitable for obtaining low electrical resistance.

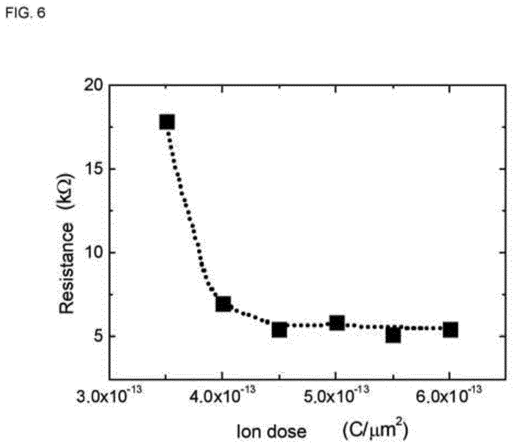

Finally, we studied the influence of the irradiation dose on the electrical resistance of the deposit: in the experiment shown in Figure 6 it can be observed that a variation of a factor 3 in the irradiation dose implies a variation of a factor 4 in the electrical resistance thereof.

Below is a comparative test which demonstrates that the method of the present invention requires a much lower amount of ion irradiation, and therefore of irradiation time, compared to a method carried out at a substrate temperature around room temperature. In Table 2, the data are compared for the same structure of about 20 nm thick grown by means of the precursor W(CO)₆.

**Table 2. Comparative data using the precursor W(CO)₆ and a structure about 20 nm thick.**

| Temperature (°C) | Ion dose per unit area (nC/µm²) | Volume of material per dose unit (µm³/nC) | Resistivity (µΩcm) |
|---|---|---|---|
| -100 | 5.5 x 10⁻⁴ | 16.35 | 423 |
| 23 | 0.399 | 2.25 x 10⁻² | 332 |

Under the working conditions of the present invention, the ion dose per area necessary is approximately a thousand factor less than in the method carried out at a substrate temperature around room temperature; the results obtained indicate that with the method of the present invention the growth rate of the material is greater by a thousand factor.

In addition, the method of the present invention does not generate defects on the substrate. In fact, measuring the composition of the "cryo-deposits" using the X-ray microanalysis technique, no presence of gallium is detected due to the low irradiation dose used. We can assume that if the gallium dose is a thousand times less, the gallium concentration will be too. In this case, the gallium concentration will be of the order of 0.01%, virtually undetectable with standard characterisation techniques (EDX, EELS, etc.).

As a comparative data, it is worth mentioning that the compositional analysis detects that the gallium content in the deposits is approximately 10% in a method carried out at a substrate temperature around room temperature (standard FIBID) [Z. Cui et al., Journal of Vacuum Science and Technology B 14 (1996) 3942].

If we translate these results into time, taking as reference the example shown in table 1, with the doses per unit area necessary, to grow a deposit of one square micron in area and 20 nm thick with an ion beam current of 10 pA, at room temperature it takes 40 seconds while at -100 °C it takes only 55 milliseconds.

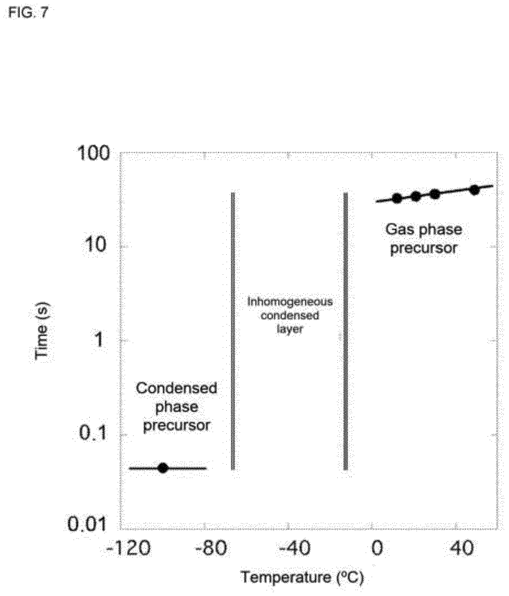

Figure 7 shows the time it takes to grow a layer of 1 m² in area and 20 nm thick as a function of the substrate temperature, we clearly see the reduction of three orders of magnitude when the precursor is in the condensed phase.

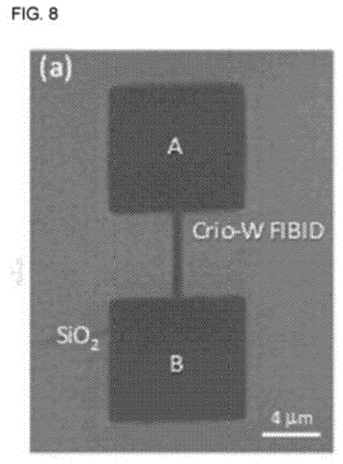

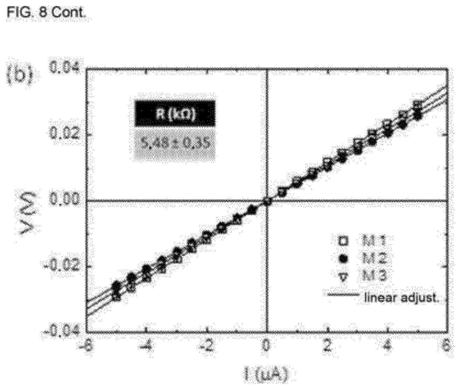

To verify that the "cryo-deposits" based on the precursor W(CO)₆ are metal, electrical measurements were carried out, as shown in Figure 8. Measurements carried out on 3 samples with similar features indicate a linear dependence between current and voltage, as expected in the case of metal behaviour. The average resistivity value obtained in these samples is 439 µΩcm, a value that is similar to that obtained in samples prepared by means of a method carried out at a substrate temperature around room temperature (standard FIBID) [7, 8]. These data confirm the metal functionality of the deposits and therefore the interest thereof in microelectronic circuit editing.

In order to find out the potential of the device of the present invention in terms of lateral resolution and packing of metal contacts in circuit editing, several nanowires were grown using doses very close to the optimum irradiation (5,5 x 10⁻⁴ nC/µm²). We can conclude from these experiments that the process described is of high lateral resolution, reaching lateral dimensions as small as 38 nm.

When a line the width of which is determined by the diameter of the beam of ions is scanned using 1 pA of current, the beam diameter is obtained which is about 10 nm.

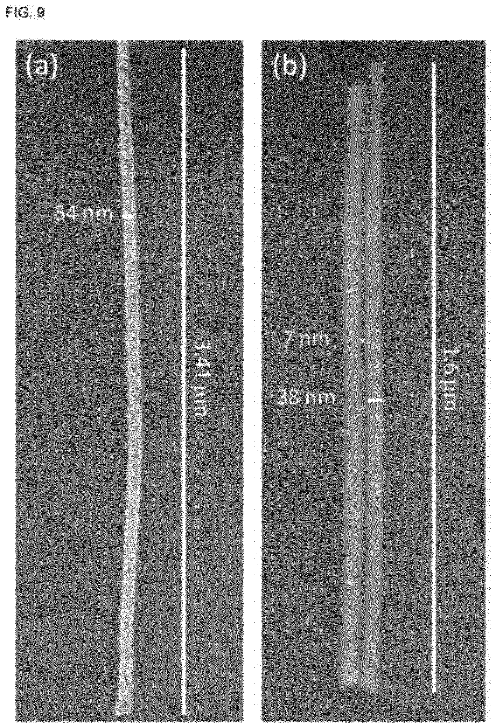

With an irradiation dose of 8 x 10⁻⁴ nC/µm², 54 nm nanowires can be grown, with an aspect (length/diameter) ratio of 63, as can be observed in Figure 9(a). While if we reduce the irradiation dose to 6 x 10⁻⁴ nC/µm² we obtain highly packed 38 nm nanowires with a distance of 7 nm between two of them, and with an aspect ratio of 42 (see Figure 9 (b)).

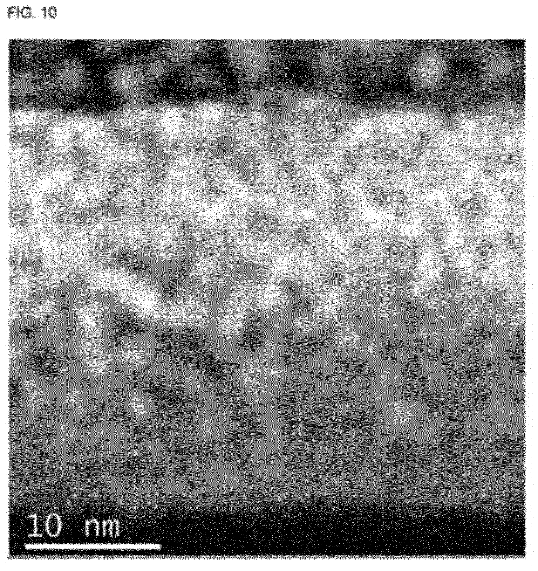

Figure 10 shows a transmission electron microscopy image of the W-C deposit obtained following the optimised method described herein, wherein the formation of a granular material with a thickness of less than 30 nm and which is conductive can be observed as the electrical measurements in Figure 8 show.

## Claims

1. A method for depositing new elements (8) on a substrate of interest (3), by means of a device that comprises
- a microscope (1) configured for visualising and identifying the position of the surface of the substrate of interest (3) and of the defective and new elements (7 and 8) that are on said substrate of interest (3)
- a focused ion beam system (2) configured for emitting a focused ion beam on the position of the surface of the substrate of interest (3) and of the defective and new elements (7 and 8) identified by the microscope (1) and for depositing new elements (8) on said substrate of interest (3)
- a precursor gas injector (6) directed towards said substrate of interest (3) and configured for depositing the new elements (8) on the substrate of interest (3) and
- a support platform of the substrate (4) connected to a cooling element (5) on which the substrate of interest is located, and configured for condensing the precursor gas coming from the precursor gas injector (6) on the substrate of interest (3),
wherein the microscope (1) and the focused ion beam system (2) are integrated into a device that contains them
wherein there is a distance between the precursor gas injector (6) and the support platform of the substrate (4), and
wherein said method is **characterised in that** it comprises the following steps
a) identifying the position of the surface of the substrate of interest (3) on which new elements (8) are to be deposited with the help of a microscope (1), and
b) depositing the new elements (8) on the position of the surface identified in step (a), forming a condensed precursor layer on the substrate of interest (3) with a thickness of up to 1 µm at a temperature higher than the condensation temperature of the substrate, irradiating the position of the surface identified in step (a) on which new elements (8) are to be deposited with a focused ion beam (2) and evaporating the condensed precursor layer.

2. The method according to claim 1, wherein the focused ion beam (2) is selected from gallium, hydrogen, helium, neon, xenon, argon, lithium, oxygen, silicon, cobalt, germanium, gold, bismuth and metal alloys.

3. The method according to any of claims 1 or 2, wherein the condensed precursor layer is formed on the substrate of interest by cooling the substrate to cryogenic temperatures below -80 °C.

4. The method according to any of claims 1 to 3, wherein the precursor is a precursor that gives rise to metal elements.

5. The method according to any of claims 1 to 4, wherein the precursor is selected from W(CO)₆, Co₂(CO)₈, and Fe₂(CO)₉, HCO₃Fe(CO)₁₂ (CH₃)₃PtCp(CH₃), CuC₁₆O₆H₂₆ or gold precursors such as dimethylgold(III)-acetyl-acetonate, dimethylgold(III)-trifluoroacetyl-acetonate, dimethylgold(III)-hexafluoroacetyl-acetonate, PF₃AuCl, Au(CO)Cl, [ClAu^{III}Me₂]₂, ClAu^{I}(SMe₂), ClAu^{I}(PMe₃) and MeAu^{I}(PMe₃).

6. The method according to any of claims 1 to 5, wherein the voltage applied for generating the ion beam in step (d) is comprised between 5 kV and 50 kV.

7. The method according to any of claims 1 to 6, wherein the irradiation with a focused ion beam (2) of step (d) is carried out in a range that is comprised between 3 x 10⁻⁴ nC/µm² and 9 x 10⁻⁴ nC/µm².

8. The method according to any of claims 1 to 7, which further comprises an additional step a'), prior to step (a), of identifying the defective elements (7) of the substrate of interest (3) with the help of a microscope (1) and roughing them out with the help of a focused ion beam (2).

9. The method according to claim 8, wherein the voltage applied for generating the ion beam in step (a') is comprised between 5 kV and 50 kV.

10. A device to rough out defective elements (7) that are located on a substrate of interest (3) and/or depositing new elements (8) on said substrate of interest (3), **characterised in that** it comprises the following elements within a high vacuum growth chamber (9)
- a microscope (1) configured for visualising and identifying the position of the surface of the substrate (3) and of the defective and new elements (7 and 8) that are on said substrate of interest (3)
- a focused ion beam system (2) configured for irradiating the position of the surface of the substrate (3) and of the defective and new elements (7 and 8) identified by the microscope (1) with a focused ion beam and to rough out defective elements (7) that are located on the substrate of interest (3) and depositing new elements (8) on said substrate of interest (3)
- a precursor gas injector (6) directed towards said substrate of interest (3) configured for depositing the new elements (8) on the substrate of interest (3) and
- a support platform of the substrate (4) connected to a cooling element (5) on which the substrate of interest (3) is located, configured for condensing the precursor gas coming from the precursor gas injector (6) on the substrate of interest (3),
wherein the microscope (1) and the focused ion beam system (2) are integrated into a device that contains them and
wherein there is a distance between the precursor gas injector (6) and the support platform of the substrate (4) that enables the thickness of the condensed precursor layer to be controlled.
